# EUROPÄISCHE PATENTSCHRIFT

(11) **EP 1 518 127 B1**
(45) Veröffentlichungstag und Bekanntmachung des Hinweises auf die Patenterteilung: **09.08.2006**
(21) Anmeldenummer: 03761441.9
(22) Anmeldetag: 30.06.2003
(51) Int. Cl.: G01R 1/04

(54) **TESTVORRICHTUNG FÜR BAUTEILE INTEGRIERTER SCHALTUNGEN**
TEST DEVICE FOR INTEGRATED CIRCUIT COMPONENTS
DISPOSITIF D'ESSAI POUR COMPOSANTS DE CIRCUITS INTEGRES

(30) Priorität: 01.07.2002 DE 10229541; 03.04.2003 DE 10315436
(43) Veröffentlichungstag der Anmeldung: 30.03.2005
(73) Patentinhaber: Infineon Technologies AG, 81669 München (DE)
(72) Erfinder: KRÄMER, Josef, 85435 Erding (DE)
(74) Vertreter: Schäfer, Horst
(86) Internationale Anmeldenummer: PCT/DE2003/002161
(87) Internationale Veröffentlichungsnummer: WO 2004/003575

(56) Entgegenhaltungen:
- EP-A- 0 622 982
- US-A- 5 076 798
- US-A- 5 477 161
- US-A1- 2001 012 707
- US-B1- 6 293 814
- PATENT ABSTRACTS OF JAPAN vol. 2000, no. 24, 11. Mai 2001 (2001-05-11) -& JP 2001 183391 A (DAITRON TECHNOLOGY CO LTD;S II R:KK), 6. Juli 2001 (2001-07-06)
- PATENT ABSTRACTS OF JAPAN vol. 1999, no. 12, 29. Oktober 1999 (1999-10-29) -& JP 11 185916 A (ENPLAS CORP), 9. Juli 1999 (1999-07-09)
- PATENT ABSTRACTS OF JAPAN vol. 2000, no. 16, 8. Mai 2001 (2001-05-08) -& JP 2001 006832 A (MITSUBISHI ELECTRIC CORP), 12. Januar 2001 (2001-01-12)
- PATENT ABSTRACTS OF JAPAN vol. 2002, no. 10, 10. Oktober 2002 (2002-10-10) -& JP 2002 164134 A (YAMAICHI ELECTRONICS CO LTD;INFINEON TECHNOLOGIES AG), 7. Juni 2002 (2002-06-07)
- PATENT ABSTRACTS OF JAPAN vol. 017, no. 579 (E-1451), 21. Oktober 1993 (1993-10-21) -& JP 05 174923 A (ENPLAS CORP), 13. Juli 1993 (1993-07-13)

## Beschreibung

Die Erfindung betrifft eine Testvorrichtung für Bauteile integrierter Schaltungen gemäß der Gattung des Anspruchs 1.

Testvorrichtungen für Bauteile integrierter Schaltungen sind erforderlich, um die Qualität und Funktionalität der integrierten Schaltungen nach Fertigstellung der Bauteile unter extremen Betriebsbedingungen prüfen zu können. Bisher wird dazu für jeden Schaltungstyp ein passender vergossener Testsockel zur Verfügung gestellt, der aufgrund seiner Kompaktheit nicht an Kleinserien anpassbar ist. Es muss folglich für jede neue Schaltungstypserie ein entsprechender kompakter voll vergossener Testsockel entworfen werden, der insbesondere bei Kleinserien bereits nach kurzer Einsatzzeit ausgedient hat.

JP 2001-183391 betrifft eine Testvorrichtung für Bauteile integrierter Schaltungen, in der das Kontaktelement gewechselt werden kann, wenn es beschädigt wird. JP 05174923 betrifft einen Testsockel, in dem die isolierenden Kontaktträger in einer Gruppe gestapelt sind, und diese Gruppe in einer Aussparung in einem Gehäuse angeordnet ist. Diese Testsockel sind nicht leicht austauschbar und sind für die Prüfung unterschiedlicher Schaltungstypen nicht konstruiert.

Aufgabe der Erfindung ist es, eine Testvorrichtung zu schaffen, mit der flexibel auf Änderungen des Schaltungstyps der elektronischen Bauteile reagiert werden kann, um insbesondere bei Kleinserien die Testkosten zu vermindern und die Zuverlässigkeit der Testergebnisse zu verbessern.

Gelöst wird diese Aufgabe mit dem Gegenstand des unabhängigen Anspruchs. Vorteilhafte Weiterbildungen der Erfindung ergeben sich aus den abhängigen Ansprüchen.

Erfindungsgemäß wird eine Testvorrichtung für Bauteile integrierter Schaltungen angegeben, die einen Testsockel aufweist. Aus diesem Testsockel ragen Kontaktelemente auf seiner Unterseite heraus, die mit Federkontakten elektrisch verbunden sind, welche aus der Oberseite des Testsockels herausragen. Dabei sind die Federkontakte mit Außenkontakten eines zu testenden integrierten Schaltungstyps elektrisch kontaktierbar. Bei der erfindungsgemäßen Testvorrichtung ist für jede Außenkontaktposition des Schaltungstyps ein Modulbaustein mit mindestens einer elektrisch leitenden Kontaktplatte und mit einer isolierenden Trägerplatte vorgesehen.

Die Kontaktplatte selbst liegt dabei in einer strukturierten Aussparung der Trägerplatte. Die Kontaktplatte ist strukturiert und weist im wesentlichen drei Abschnitte auf, nämlich einen Kontaktabschnitt, einen Federabschnitt und einen Halteabschnitt, wobei der Halteabschnitt jeweils mindestens eines der aus der Unterseite des Testsockels herausragenden Kontaktelemente hält. Die Gesamtheit der Modulbausteine bildet den Testsockel für den vorgegebenen integrierten Schaltungstyp, wozu die Modulbausteine zu einem Stapel zusammengebaut sind.

Diese Testvorrichtung hat den Vorteil eines modularen Aufbaus, so dass sie an jeden unterschiedlichen Schaltungstyp angepasst werden kann, ohne dass ein massiver neuer Testsockel zu gießen ist. Vielmehr kann der Testsockel an die Anzahl der Außenkontakte oder Außenkontaktpositionen des zu testenden Bauteils und an das Rastermaß der Außenkontakte des zu testenden Bauteils variabel angepasst werden. Dazu kann eine geringe Anzahl von nur einem Modulbaustein den Testsockel bilden oder auch eine beliebig hohe Anzahl kann zu einem Testsockel gestapelt werden. Entscheidend ist, dass die Kontaktplatten derart dicht aneinander angeordnet werden können, dass die kleinsten möglichen Schrittweiten oder Rastermaße von Anschlußkontakten von Bauteilen mit integrierten Schaltungen zusammengestellt werden können. Dabei ist eine Schrittweite von 1 mm bis hinunter auf 0,3 mm möglich und wird durch die Materialstärke des Modulbausteins bestimmt.

Ein weiterer Vorteil dieser Konstruktion ist, dass die Kontaktplatten von den Trägerplatten geführt werden und somit weder verkanten noch sich verbiegen können, zumal die strukturierte Kontaktplatte in einer entsprechend vorgeformten und strukturierten Aussparung der Trägerplatte angeordnet ist. Darüber hinaus hat die Modulbauweise den Vorteil, dass kürzere Signalwege aufgrund des Wegfalls von zusätzlichen Adapterleiterplatten erreicht werden. Damit vermindert sich auch die Leitungsimpedanz in Bezug auf Induktivitäten und Kapazitäten. Durch den Wegfall derartiger Adapterleiterplatten, wie sie für vergossene Testsockel erforderlich sind, können auch höhere Versorgungsströme beim Einsatz der erfindungsgemäßen Testvorrichtung erreicht werden, die bei der erfindungsgemä-ßen Testvorrichtung weit über 20 Ampere liegen können.

In dem Folgenden werden nun Ausführungsformen der einzelnen Abschnitte der strukturierten Kontaktplatte, ihre Eigenheiten und ihre Vorteile beschrieben.

Die Federkontakte der Kontaktplatte können im Bereich der Kontaktabschnitte der Kontaktplatte eine oxidations- oder e-rosionsfeste Beschichtung aufweisen, die aus einem Edelmetall, vorzugsweise aus Gold, besteht, zumal Gold den geringsten Kontaktwiderstand und die größte Kontaktlebensdauer aufweist, da weder eine Oxidation noch eine Sulfidation an Luft stattfindet. Auch die Kontaktelemente auf der Unterseite des Testsockels können mit derartigen Beschichtungen vor Korrosion, Oxidation oder Sulfidation geschützt sein. Die Kontaktplatte selbst kann eine Federbronze wie Berilliumbronze aufweisen, die aufgrund ihrer elastischen Eigenschaften eine hohe Lebensdauer der Federkontakte ermöglicht.

In einer Ausführungsform der Erfindung kann der Modulbaustein für jeden Außenkontakt zwei voneinander isoliert in zwei Aussparungen angeordnete Kontaktplatten mit jeweils zwei Federkontakten aufweisen, die beim Testen mit einem einzelnen Außenkontakt verbunden sind. Von diesen beiden strukturierten Kontaktplatten sind auf der Unterseite des Testsockels zwei Kontaktelemente angeordnet, die elektrisch voneinander isoliert mit den zwei zugehörigen Federkontakten verbunden sind, wobei die eine Kontaktplatte über ihren Federkontakt ein Prüf- oder Testsignal an den Außenkontakt des zu testenden Bauteiles legt, während die andere Kontaktplatte mit ihrem Federkontakt sicherstellt, dass das Prüfsignal an dem Außenkontakt anliegt. Diese Struktur hat den Vorteil, dass während des Testvorgangs das Anliegen der Prüfsignale messtechnisch von dem jeweils zweiten Federkontakt eines Kontaktplattenpaares sichergestellt wird womit die Zuverlässigkeit der Testergebnisse verbessert wird.

Die mindestens eine Kontaktplatte weist neben dem Kontaktabschnitt auch einen Federabschnitt auf. Dieser Federabschnitt kann durch einen Spiralfederbogen realisiert werden, der sich an dem Kontaktabschnitt der Kontaktplatte anschließt und dessen Federkräfte ebenfalls von dem Halteabschnitt der Kontaktplatte aufgenommen werden. Dazu ist sowohl der Kontaktabschnitt als auch der Federabschnitt der Kontaktplatte in der strukturierten Aussparung der Trägerplatte mit einer Spielpassung eingebaut, die 0,2 bis 0,3 mm aufweist, um eine entsprechende Kontaktfederauslenkung des Kontaktabschnittes und damit des Federkontaktes zuzulassen.

Anstelle des Spiralfederbogens kann auch eine Federspange vorgesehen werden. Eine derartige Federspange hat den Vorteil, dass sie kompakter unter geringerem Platzbedarf auf den Aussparungen der Trägerplatte vorgesehen werden kann. Der Federabschnitt kann anstelle einer Spange oder eines einzelnen Spiralbogens auch ein S-förmiges Federelement aufweisen, das gegenüber einer Federspange weicher nachfedert und somit eine geringere Federkonstante aufweist.

Zur Unterseite des Testsockels hin schließt sich an den Halteabschnitt mindestens ein aus dem Testsockel herausragendes Kontaktelement pro Kontaktplatte an. Dieses Kontaktelement kann entweder starr von einem Teststift dargestellt sein oder elastisch durch eine Kontaktfeder, die mit dem Halteabschnitt verbunden ist, realisiert werden. Wird das aus der Unterseite herausragende Kontaktelement durch eine Kontaktfeder dargestellt, so kann diese unmittelbar durch ihren Federkontakt auf eine Prüfplatte einwirken. Dazu kann die Kontaktfeder auf der Unterseite des Testsockels als Spreizfeder ausgebildet sein und federelastisch von dem Halteabschnitt der Kontaktplatte weggespreizt sein. Der Federdruck einer solchen Spreizfeder kann durch die Länge des Federarms und durch den Querschnitt des Spreizfedermaterials den Erfordernissen eines Testsockels angepasst werden. Ein Vorteil dieser Anordnung ist es, dass die Signalwege von der Prüfplatte durch die Kontaktfeder zu den auf der Oberseite des Testsockels herausragenden Federkontakten sehr kurz sind, so dass die Leitungsimpedanz aus Induktivitäten und Kapazitäten vermindert wird.

Bei einer federelastischen Verbindung zwischen Prüfplatte und Kontaktfeder besteht jedoch kein Abstand zwischen Prüfplatte und der Unterseite des Testsockels. Ein derartiger Abstand ist jedoch mit starren Teststiften realisierbar, so dass dafür gesorgt werden kann, dass die Prüfplatte thermisch von der Unterseite des Testsockels, der den Testtemperaturen in der Testvorrichtung ausgesetzt ist, entkoppelt werden kann.

Dazu weist jede Kontaktplatte ein aus der Unterseite herausragendes starres Kontaktelement als Teststift auf. Zur Aufnahme von zylindrischen Teststiften, die aus dem Testsockel herausragen, weist die Testvorrichtung eine Prüfplatte mit Steckbuchsen auf. Diese Prüfplatte kann in einem Abstand von der Unterseite des Testsockels angeordnet sein, wobei dieser Abstand von den zylindrischen Teststiften überbrückt wird. Diese Testbuchsen weisen analog zu der Anordnung der zylindrischen Teststifte eine entsprechende Anordnung in der Prüfplatte auf, so dass für jeden Modulbaustein mindestens eine Steckbuchse in der Prüfplatte vorhanden ist.

Da der Modulbaustein auch paarweise angeordnete Federkontakte aufweisen kann, können auch mehrere Teststifte aus einem einzelnen Modulbaustein herausragen. Es ist aufgrund des erfindungsgemäßen Grundgedankens kein Problem, sechs und mehr parallel angeordnete Federkontakte auf einem Modulbaustein unterzubringen. Eine Ausführungsform mit sechs Federkontakten auf einem Modulbaustein wird später mit entsprechenden Figuren näher erläutert.

Während der Halteabschnitt der Kontaktplatte mehrere starre Kontaktelemente aufweist, die als Vierkantstifte aus der Unterseite des Testsockels herausragen, kann der Abstand zwischen der Unterseite des Testsockels und einer Prüfplatte durch zylindrische Teststifte erreicht werden, die auf die Vierkantstifte kraftschlüssig steckbar sind. Somit können die Vierkantstifte, die aus dem Material und mit der Materialstärke des Halteabschnitts hergestellt sind, durch die zylindrischen Teststifte beliebig verlängert werden.

Die von den Halteabschnitten der Kontaktplatte gehaltenen und aus dem Testsockel herausragenden Kontaktelemente der einzelnen Modulbausteine sind versetzt zueinander angeordnet. Diese versetzte Anordnung ermöglicht eine größere Durchschlagsspannungsfestigkeit des Testsockels, insbesondere der Kontaktelemente. Diese Durchschlagsfestigkeit für die zueinander versetzt angeordneten Kontaktelemente soll 1 kV nicht unterschreiten. Der Querschnitt der Kontaktelemente ist dabei an den Querschnitt der Federkontakte, die mit den Außenkontakten eines zu testenden Bauteils kontaktierbar sind, angepasst. Um Überlastungen der Kontaktelemente zu vermeiden, kann der Querschnitt der Kontaktelement zwischen 10 und 30 % größer sein als der Querschnitt der Federkontakte.

Auf der Unterseite des Testsockels können die Kontaktelemente, soweit sie als Kontaktfedern ausgebildet sind, unmittelbar mit einer Umverdrahtungsstruktur für eine Prüfplatte oder auf einer Prüfplatte elektrisch verbunden sein. Wie bereits oben erwähnt, werden dadurch die Signalwege verkürzt und somit die Leitungsimpedanz vermindert. Mit dem Umverdrahtungsmuster einer Prüfplatte können auch starre Kontaktelemente in Form von zylindrischen Teststiften in Verbindung gebracht werden, indem auf der Prüfplatte Steckbuchsen vorgesehen werden, die ihrerseits mit dem Umverdrahtungsmuster in elektrischer Verbindung stehen.

Jeder Modulbaustein der vorliegenden Erfindung weist eine Materialstärke zwischen 0,3 mm und 1 mm auf. Mit dieser Materialstärke werden eng nebeneinander liegende Federkontakte auf dem Testsockel realisiert und damit kann ein Bauteil mit äußerst niedriger Schrittweite der Außenkontakte mit Hilfe der erfindungsgemäßen Testvorrichtung geprüft werden. Um diese Materialstärke der Modulbausteine zu erreichen weist auch die Trägerplatte eine Gesamtmaterialstärke in der gleichen Größenordnung, nämlich von 0,3 mm bis 1 mm, auf. Darüber hinaus weist die Trägerplatte eine minimale Materialstärke im Bereich der Aussparungen, in denen die Kontaktplatte unterzubringen ist, auf. Für diese Bereiche weist die Trägerplatte eine minimale Materialstärke ≥ 0,05 mm auf.

Der Minimalwert der Materialstärke der Trägerplatte wird im wesentlichen durch den Isolationswiderstand bestimmt, der durch die Trägerplatte zu erreichen ist. Als Material weist deshalb die Trägerplatte Polyimid, Polyethylen, Polystyrol, Polytetrafluorethylen oder ein Epoxidharz auf. Derartige Kunststoffe können, um die Stabilität der Trägerplatte zu realisieren, durch keramische Fasern oder Glasfasern verstärkt sein. Die Materialstärke der Kontaktplatte, die in den Aussparungen der Isolationsplatte untergebracht ist, weist einen Wert von 0,05 bis 0,750 mm auf und ist der Tiefe der entsprechenden Aussparungen angepasst.

Um die Position des Halteabschnitts der Kontaktplatte in den Aussparungen der Trägerplatte zu sichern, kann die Kontaktplatte im Bereich des Halteabschnitts eine Passöffnung aufweisen, in die ein angepasster Vorsprung der Trägerplatte eingreift. Dieser angepasste Vorsprung kann die volle Stärke der Trägerplatte aufweisen und damit verhindern, dass sich der Halteabschnitt der Kontaktplatte gegenüber der Trägerplatte verschiebt. Diese Fixierung der Kontaktplatte im Bereich des Halteabschnitts ist deshalb entscheidend, weil der Halteabschnitt gleichzeitig das Kontaktelement hält und somit die Kräfte, die beim Einführen eines Teststiftes in die Steckbuchsen der Prüfplatte oder die Kräfte, die beim Aufpressen von Kontaktfedern auf die Prüfplatte aufzubringen sind, aufnimmt.

Anstelle einer Passöffnung im Bereich des Halteabschnitts der Kontaktplatte kann die Kontaktplatte auch eine Arretierfahne im Halteabschnitt aufweisen, die in eine angepasste Aussparung der Trägerplatte eingreift. Eine derartige Arretierfahne hat den Vorteil, dass es den Querschnitt des Halteabschnitts nicht schwächt, wie das durch eine Passöffnung erfolgen könnte. Damit die Arretierfahne dafür sorgt, dass die Kontaktierungskräfte für die Kontaktelemente von dem Halteabschnitt aufgefangen werden, ist die Arretierfahne parallel zur Unterseite des Testsockels in der angepassten Aussparung der Trägerplatte passgenau angeordnet.

Um ein genaues Aufeinanderstapeln der Modulbausteine zu erreichen, weist jeder Modulbaustein mindestens zwei Passöffnungen auf, durch welche Zentrierbolzen führen, die zwei Endstücke miteinander verbinden. Die Endstücke sind flächenkongruent an die Modulbausteine angepasst und können den Stapel aus Modulbausteinen zu einem Testsockel zusammenpressen. Dazu sind auch in den Endstücken entsprechende Passbohrungen vorgesehen, die von den Führungs- oder Zentrierbolzen durchstoßen werden. Somit ergibt sich beim Aufbringen der Endstücke auf die Modulbausteine ein exakt positionierter Stapel aus Modulbausteinen zwischen den Endstücken, mit dem der Testsockel für die erfindungsgemäße Testvorrichtung realisiert wird. Dazu kann eines der Eckstücke mit den Zentrierbolzen fest verbunden sein, während das zweite Eckstück über Schraubverbindungen die Modulbausteine in Position hält.

Zum sicheren Positionieren und Andrücken des zu testenden Bauteils bei einzelnen Vortests eines Testsockels können die Endstücke einen Rahmen tragen, der seinerseits eine Schwenkvorrichtung aufweist. Diese Schwenkvorrichtung für einzelne Vortests eines Testsockels kann auf ein zu testendes Bauteil mit integrierter Schaltung unter Federkontaktgabe zwischen den Außenkontakten des zu testenden Bauteils und den Federkontakten der Modulbausteine des Testsockels geschwenkt werden. Dazu weist die Schwenkvorrichtung einen Einsatz auf, welcher der Kontur des zu testenden Bauteils angepasst ist und in einer Verriegelungsposition der Testvorrichtung das Bauteil mit seinen Außenkontakten auf die Federkontakte des Testsockels presst.

Um diese Verriegelungsposition zu halten und zu definieren, weist der Rahmen eine gegenüber der Schwenkvorrichtung liegende Schnappvorrichtung auf. Mit dieser Schnappvorrichtung kann die Schwenkvorrichtung zur Fixierung des zu testenden Bauteils in Eingriff gebracht werden. Das hat den Vorteil, dass der automatische Qualitäts- und Funktionstest des elektronischen Bauteils in einer Verriegelungsposition durchgeführt werden kann, ohne dass weitere Maßnahmen zum Zuführen und Halten des Bauteils bei einzelnen Vortests des Testsockels erforderlich sind. Ein derartiger Einsatz kann in vorteilhafter Weise als Wärmeübertrager konstruiert sein und das zu testende Bauelement in der Arretierposition je nach Testbedingungen kühlen oder aufheizen.

Die Schnappvorrichtung kann eine U-förmige Klinke aufweisen, mit der ein stabförmiges Bedienelement der Schwenkvorrichtung in der Verriegelungsposition der Testvorrichtung in Eingriff steht. Beim Verriegeln greift das stabförmige Bedienelement der Schwenkvorrichtung in die U-förmige Klinke der Schnappvorrichtung ein und der Einsatz der Schwenkvorrichtung drückt auf die Rückseite des zu testenden Bauteils und presst damit die Außenkontakte des Bauteils auf die Federkontakte des Testsockels. Somit wird eine zuverlässige und sichere Kontaktgabe erreicht und ein entsprechend zuverlässiger Qualitäts- und Funktionstest garantiert.

Eine weitere Ausführungsform der Erfindung sieht vor, dass die Testvorrichtung vier Endstücke und zwei Stapel aus Modulbausteinen aufweist. Jeder Stapel aus Modulbausteinen bildet dabei eine Testsockelhälfte. In der Testvorrichtung sind diese beiden Testsockelhälften einander gegenüberliegend angeordnet. Im Prinzip können auch acht Endstücke mit entsprechend vier Stapeln aus Modulbausteinen vorbereitet sein, wobei die Stapel aus Modulbausteinen lediglich jeweils ein Viertel eines Testsockels darstellen. In jedem Falle werden dann die vier Stapel in einem Quadrat gegenübergestellt und können somit integrierte Schaltungstypen mit quadratisch angeordneten Außenkontakten testen.

Bei zwei Stapeln aus Modulbausteinen können die Testsockelhälften einander gegenüberliegend angeordnet sein und auf einer Grundplatte durch entsprechende Passschrauben, die durch die Endstücke geführt werden, in Position gehalten sein. Damit ist der Vorteil verbunden, dass die erfindungsgemäße Testvorrichtung mit ihrer Modulbauweise äußerst flexibel ist und an jeden unterschiedlichen Schaltungstyp angepasst werden kann. Auch die Zahl der Modulbausteine und damit die Zahl der Außenkontakte eines zu testenden Bauteils werden durch diese Testvorrichtung in keiner Weise begrenzt oder vorgeschrieben. Vielmehr kann die Testvorrichtung für die unterschiedlichsten Schaltungstypen mit zwei Kontaktelementen bis zu mehreren Tausend Kontaktelementen ausgebaut werden. Dazu sind die Endstücke, die Zentrierbolzen und/oder die Passschrauben aus einem Chrom-Nickel-Stahl hergestellt, da sich Bauteile aus derartigen Stählen oxidationsfest und passgenau herstellen lassen.

Zusammenfassend ist festzustellen, dass der Aufbau und die Konstruktion der vorgeschlagenen Testvorrichtung sich von heute käuflichen Testvorrichtungen durch ihre Modularität und ihre kurzen Signalwege unterscheidet. Bei der vorliegenden Erfindung ist der Sockel nicht aus einem Guss gefertigt, sonder pro Außenanschluss oder pro Außenanschlusspaar ist er in Module gegliedert. Diese Module können beliebig in der Anzahl und Anordnung variiert werden, aneinandergereiht werden oder gegenübergestellt werden. Durch die kürzeren Signalwege aufgrund des Wegfalls von zusätzlichen Adapterleiterplatten werden verminderte Imaginäranteile der Leitungsimpedanz in Bezug auf Induktivität und Kapazität erreicht. Durch den Wegfall einer Adapterleiterplatte sind höhere Versorgungsströme beim Einsatz der Testvorrichtungen möglich, die mehr als 20 Ampere betragen können.

Die Erfindung wird nun anhand von Ausführungsformen mit Bezug auf die beiliegenden Figuren näher erörtert.
- Figur 1: zeigt eine schematische perspektivische Ansicht einer Testvorrichtung einer ersten Ausführungsform der Erfindung für Einzeltests und Vortests eines Testsockels,
- Figur 2: zeigt eine schematische perspektivische Ansicht eines zu testenden Bauteils mit Führungsrahmen,
- Figur 3: zeigt eine schematische auseinandergezogene perspektivische Ansicht eines Testsockels einer zweiten Ausführungsform der Erfindung,
- Figur 4: zeigt eine schematische perspektivische Ansicht eines teilweisen Zusammenbaus des Testsockels der Figur 3,
- Figur 5: zeigt den vollständigen Zusammenbau des Testsockels der Figur 3,
- Figur 6: zeigt eine schematische auseinandergezogene perspektivische Ansicht einer Testsockelhälfte einer dritten Ausführungsform der Erfindung,
- Figur 7: zeigt eine schematische perspektivische Ansicht einer Testsockelhälfte mit Blick auf die Teststifte eines auf einem Eckstück aufgelegten Modulbausteins,
- Figur 8: zeigt eine schematische perspektivische Ansicht eines Eckstücks einer Testsockelhälfte mit Blick auf die Federkontakte von acht aufeinandergestapelten Modulbausteinen.
- Figur 9: zeigt eine schematische perspektivische Ansicht einer Testvorrichtung einer vierten Ausführungsform der Erfindung mit einem Testsockel für Funktions-Testserien von Bauteilen integrierter Schaltungen,
- Figur 10: zeigt eine schematische perspektivische Ansicht von zwei Kontaktplatten mit zwei Federkontakten zum gemeinsamen Kontaktieren und Verbinden eines einzelnen Außenkontaktes eines Bauteils mit Teststiften auf der Unterseite eines Testsockels,
- Figur 11: zeigt eine schematische Seitenansicht eines Teils eines Modulbausteins mit Kontaktplatten, wie sie in Figur 10 gezeigt werden, mit Teststiften zu einer Prüfplatte,
- Figur 12: zeigt eine schematische Seitenansicht einer Kontaktplatte,
- Figur 13: zeigt eine schematische perspektivische Ansicht von zwei Kontaktplatten zum gemeinsamen Kontaktieren und Verbinden eines einzelnen Außenkontaktes eines Bauteils mit Kontaktfedern auf der Unterseite des Testsockels,
- Figur 14: zeigt eine schematische Seitenansicht eines Teils eines Modulbausteins mit Kontaktplatten, wie sie in Figur 13 gezeigt werden, mit Kontaktfedern zu einer Prüfplatte.

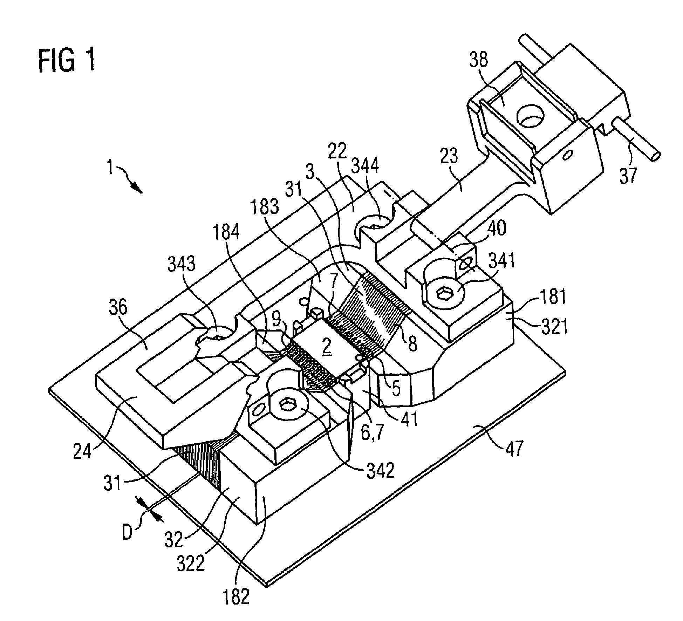

Figur 1 zeigt eine schematische perspektivische Ansicht einer Testvorrichtung 1 einer ersten Ausführungsform der Erfindung für Einzeltests und Vortests eines Testsockels. Mit dem Bezugszeichen 2 wird ein Bauteil einer integrierten Schaltung gekennzeichnet. Das Bezugszeichen 3 kennzeichnet den Testsockel, der in dieser Ausführungsform der Erfindung aus zwei Testsockelhälften 321 und 322 besteht. Das Bezugszeichen 5 kennzeichnet eine Vielzahl von Federkontakten auf dem Testsockel 3 und das Bezugszeichen 6 kennzeichnet die Außenkontakte des zu testenden Bauteils eines Schaltungstyps. Das Bezugszeichen 7 kennzeichnet die einzelnen Außenkontaktpositionen, in denen jeweils ein Modulbaustein 8 angeordnet ist. Das Bezugszeichen 18 kennzeichnet Endstücke, wobei diese Ausführungsform der Erfindung vier Endstücke umfasst, nämlich 181, 182, 183 und 184, zwischen denen die Modulbausteine 8 angeordnet und passgenau eingesetzt sind.

Die vier Endstücke 181, 182, 183 und 184 tragen einen Rahmen 22, der mit vier Passschrauben 341, 342, 343 und 344 mit den Endstücken verbunden ist und die gleichzeitig die beiden Sockelhälften 321 und 322 auf einer Grundplatte 33 befestigen.

Das Bezugszeichen 23 kennzeichnet eine Schwenkvorrichtung, die um die Achse 40 schwenkbar ist und ein stabförmiges Bedienelement 37 aufweist, mit dem die Schwenkvorrichtung 23 mit einer gegenüberliegend auf dem Rahmen 22 angeordneten Schnappvorrichtung 24 in Eingriff bringbar ist. Die Schnappvorrichtung 24 weist eine U-förmige Klinke 36 auf, in die das stabförmige Bedienelement 37 einklinken kann.

Das Bezugszeichen 38 kennzeichnet einen Einsatz in der Schwenkvorrichtung 23, der in einer Verriegelungsposition der Schwenkvorrichtung 23 mit der Schnappvorrichtung 24 das Bauteil 2 mit seinen Außenkontakten 6 auf die Federkontakte 5 der Modulbausteine 8 presst.

Der in Figur 1 gezeigte Rahmen 22 mit der Schwenkvorrichtung 23 und der Schnappvorrichtung 24 ist nur für Einzeltests sowie Funktionstests eines Testsockels 3 mit Musterbauteilen 2 von unterschiedlichen integrierten Schaltungstypen erforderlich. Für den Serientest in einer automatischen Testvorrichtung, die bei hohem Durchsatz an integrierten Schaltungen bei niedrigen Temperaturen bis -50°C und bei hohen Temperaturen bis 150°C Funktionstests durchführt, wird lediglich der Testsockel in die automatische Testvorrichtung eingespannt beziehungsweise bei Schaltungstypwechsel, Wartungs- und Instandsetzungsarbeiten der Testsockel ausgewechselt. Die Aufbauten auf dem Rahmen 22 sind dann nicht mehr erforderlich.

Die Materialstärke D eines jeden der Modulbausteine 8 liegt zwischen 0,3 mm und 1 mm, so dass der Testsockel 3 beziehungsweise die Testvorrichtung 1 in dieser Ausführungsform ein Rastermaß für die Außenkontakte des elektronischen Bauteils von 0,3 bis 1 mm zum Testen aufnehmen kann. Die modulare Bauweise dieser Testvorrichtung 1 ermöglicht es, die Anzahl der Federkontakte auf der Oberseite des Testsockels sowie die Schrittweite oder das Rastermaß der Kontakte an die verschiedenen zu testenden Bauteile mit unterschiedlichen Schaltungstypen anzupassen und eine breite Palette von Testsockeln für unterschiedliche Bauteile zur Verfügung zu stellen. Dabei wird lediglich die Anzahl, Materialdicke und Struktur der Modulbausteine 8 an den Schaltungstyp des jeweiligen Bauteils angepasst.

Zum Testen kann das zu testende Bauteil auf den Testsockel 3 aufgesetzt werden. Danach wird die Schwenkvorrichtung um die Achse 40 geschwenkt, so dass der Einsatz 38 der Schwenkvorrichtung auf das Bauteil 2 drücken kann, während das Bedienelement 37 mit der Schnappvorrichtung 24 in Eingriff gebracht wird. Der Einsatz 38 kann dabei gleichzeitig als Wärmeleiter ausgebildet sein, so dass eine intensive Kühlung oder intensive Erwärmung des zu testenden Bauteils und des Testsockels während der Testphase gewährleistet werden kann.

Andererseits können in den Modulbausteinen spezielle Federkontakte vorgesehen werden, welche die Rückseite des elektronischen Bauteils kontaktieren, um den Isolationswiderstand des Bauteilgehäuses zu den Außenkontakten zu prüfen. Schließlich kann in dieser Ausführungsform der Erfindung die Testvorrichtung so gestaltet werden, dass ein Isolationswiderstandstestblock 41 zwischen den beiden Testsockelhälften 321 und 322 angeordnet wird, der die Rückseite des zu testenden elektronischen Bauteils während der Testphase kontaktiert.

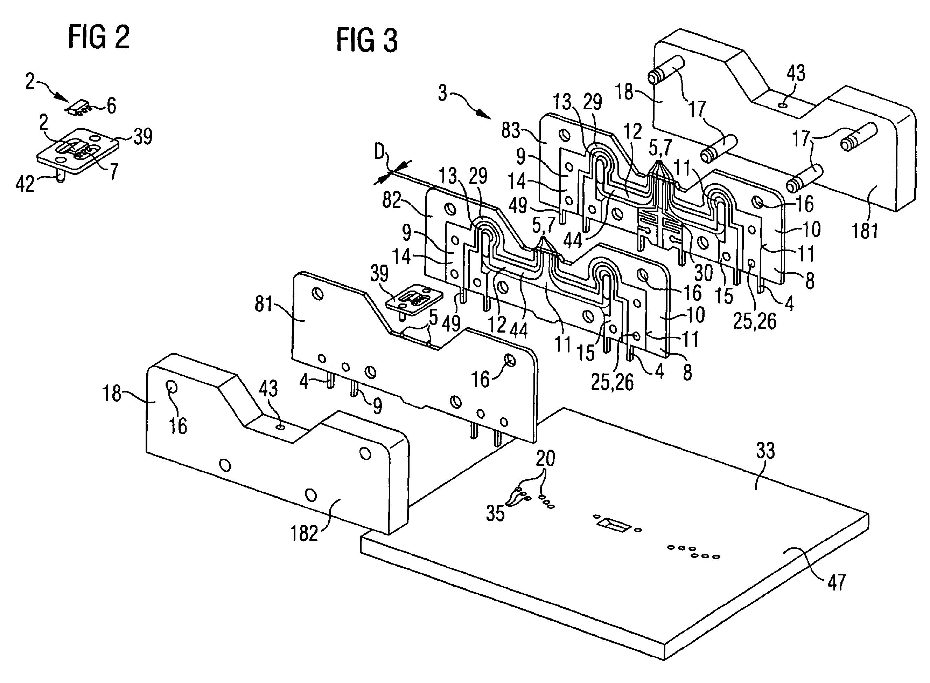

Figur 2 zeigt eine schematische perspektivische Ansicht eines zu testenden Bauteils mit Führungsrahmen. Komponenten mit gleichen Funktionen wie in Figur 1 werden mit gleichen Bezugszeichen gekennzeichnet und nicht extra erörtert. Dieses elektronische Bauteil 2 eines integrierten Schaltkreises weist lediglich sechs Außenkontakte 6 auf. Aufgrund der minimalen Größe dieses Bauteils ist ein Führungsrahmen 39 vorgesehen, in den das elektronische Bauteil 2 zur Erleichterung der Handhabung vor dem Test eingelegt werden kann. Der Führungsrahmen 39 weist zwei Zentrierbolzen 42 auf, die passgenau in entsprechende Zentrierbohrungen der Endstücke eines Testsockels eingeführt werden können.

Figur 3 zeigt eine schematische auseinandergezogene perspektivische Ansicht eines Testsockels 3 einer zweiten Ausführungsform der Erfindung. Komponenten mit gleichen Funktionen wie in den Figuren 1 und 2 werden mit gleichen Bezugszeichen gekennzeichnet und nicht extra erörtert.

Der Testsockel 3 wird durch zwei Eckstücke 181 und 182 zusammengehalten. Dazu stehen aus dem Eckstück 181 vier Zentrierbolzen 17 heraus, die mit Passöffnungen 16 der Modulbausteine 8 zusammenwirken und eine genaue Positionierung und Stapelung der Modulbausteine 8 auf dem Eckstück 181 gewährleisten. Das zweite Eckstück 182 weist entsprechende Passöffnungen 16 auf und kann für den Zusammenbau des Testsockels 3 auf die Zentrierbolzen 17 des Eckstückes 181 geschoben werden.

Zur Fixierung der beiden Eckstücke mit den dazwischenliegenden oder dazwischen angeordneten Modulbausteinen 8 sind auf den Führungsbolzen 17 an ihren freistehenden Enden Ringnuten vorgesehen, über die nach der Stapelung von Modulbausteinen 8 und zweitem Eckstück 182 Spreizfederscheiben zur Arretierung und Fixierung geschoben werden können. Außerdem weisen die Eckstücke 181 und 182 Zentrierbohrungen 43 auf, in die zum Testen der Führungsrahmen 39 mit seinen Zentrierbolzen 42 zum Testen des vom Führungsrahmen 39 gehaltenen elektronischen Bauteils 2 eingeführt werden kann. Entsprechend der sechs paarweise angeordneten Außenkontakte 6 des elektronischen Bauteils 2 sind drei Modulbausteine für jedes der drei Paare von Außenkontakten 6 vorgesehen.

In Figur 3 werden drei unterschiedlich konstruierte Modulbausteine 81, 82 und 83 dargestellt. Zum Testen des elektronischen Bauteils 2 werden entweder drei Modulbausteine des Typs 81 oder drei Modulbausteine des Typs 82 oder drei Modulbausteine des Typs 83 eingesetzt. Von dem Modulbaustein 81 sind lediglich die Hauptfunktionsträger des Modulbausteins dargestellt. Dieses sind einmal die Federkontaktspitzen 5, die aus dem Modulbaustein angepasst an die Schrittweite der Außenkontakte und den Abstand von zwei Außenkontakten eines Außenkontaktpaares des Bauteils angeordnet sind und aus dem Modulbaustein 81 federelastisch herausragen. Zum anderen sind es die Vierkantstifte 49, die als Kontaktelemente 4 der Unterseite des Testsockels 3 mit den Federkontakten 5 der Oberseite des Testsockels 3 elektrisch verbunden sind und starr nach unten aus dem Modulbauteil 81 zum Einsatz in die Prüfplatte 47 herausragen. Und schließlich sind mit dem Modulbaustein 81 die Lage und Größe der Passöffnungen 60 gekennzeichnet, die mit den Zentrierbolzen 17 des Endstückes 181 zusammenwirken.

Mit dem Modulbaustein 82 der Figur 3 wird die Verbindung zwischen den starren Vierkantstiften 49 und den elastischen Federkontakten 5 dargestellt. Diese Verbindung zwischen den Vierkantstiften 49 und den Federkontakten 5 wird im wesentlichen durch eine Kontaktplatte 15 erreicht, wobei jeder der Vierkantstifte 49 mit einer derartigen Kontaktplatte 15 verbunden ist, die aus drei Abschnitten besteht, einem Halteabschnitt 14, der den Vierkantstift 49 hält und mit einem Federabschnitt 13 verbunden ist, wobei der Federabschnitt 13 in einen Kontaktabschnitt 12 übergeht, der an seinem freien Ende den Federkontakt 5 aufweist. Der Federabschnitt 13 bewirkt eine Federkraft der Federkontakte 5 auf einen Außenkontakt eines elektronischen Bauteils von 38 bis 50 g. Dazu wird eine Kontaktplatte eingesetzt, die eine Federbronze, wie Berilliumbronze, aufweist.

Während der Halteabschnitt 14 in einer Aussparung einer Trägerplatte 8 passgenau angeordnet ist, ist für den Federabschnitt 13 eine Spielpassung in der Aussparung der Trägerplatte 10 vorgesehen, so dass der Federkontakt zwischen 0,2 und 0,3 mm federnd nachgeben kann. In dieser Ausführungsform des Modulbausteins 82 ist der Federabschnitt 13 der Kontaktplatte 15 als Spiralfederbogen ausgebildet, an den sich ein relativ steifer Arm 44 anschließt, der den Federkontakt 5 trägt. Für jeden der Außenkontakte 6 des elektronischen Bauteils sind zwei Federkontakte 5 vorgesehen, um eine sichere Kontaktierung zu ermöglichen. Die Spitze des Federkontaktes ist mit einem Edelmetall wie Gold beschichtet, um den Kontaktwiderstand zu minimieren und sicherzustellen, dass der Federkontakt weder erodiert noch oxidiert. Jedoch verschmutzen die Federkontakte durch Migration der Metalle wie Zinn und Blei der zu testenden Außenkontakte.

Der Halteabschnitt 14 der Kontaktplatte 15, der in den Vierkantstift 49 übergeht, welcher aus der Trägerplatte 10 herausragt, ist gegen Verschieben zusätzlich durch eine Passöffnung 25 gesichert. In diese Passöffnung 25 ragt ein angepasster Vorsprung 26 der Trägerplatte hinein, wodurch ein Verschieben der Kontaktplatte beim Einführen der Vierkantstifte 49 in entsprechende Steckbuchsen 20 der Prüfplatte 47 verhindert wird. Die Dicke D des Modulbausteins 82 entspricht der Dicke D der isolierenden Trägerplatte 10.

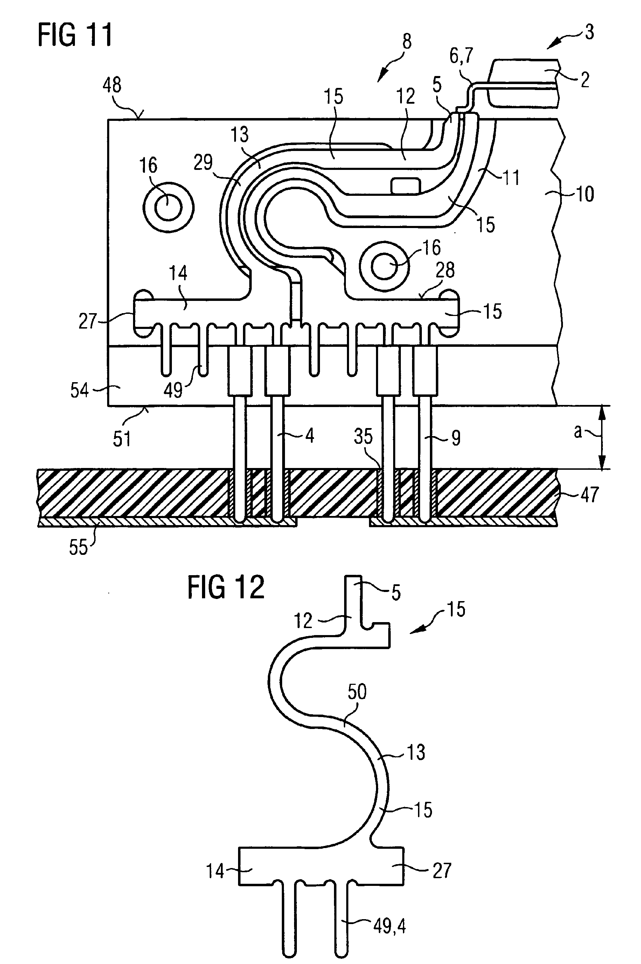

Eine dritte Ausführungsform eines Modulbausteins 8 wird mit dem Modulbaustein 83 gezeigt, der neben den bereits erläuterten Kontaktplatten des Modulbausteins 82 zwei weitere Kontaktplatten aufweist. Diese Kontaktplatten sorgen für zwei zusätzliche Federkontakte, die beispielsweise zur Isolationswiderstandsmessung gegen den Boden des elektronischen Bauteils 2 drücken können. Die Federkraft dieser zentralen Federkontakte 5 wird durch eine Federspange 30 im Federabschnitt 13 der Kontaktplatte 15 aufgebracht. Anstelle einer Federspange kann auch S-förmiges Federelement 50 eingesetzt werden, wie es in Figur 12 gezeigt wird.

Eine derartige Federspange hat gegenüber einem Spiralbogen 29 den Vorteil einer kompakteren Bauweise und kann mit einer größeren Federkonstanten ausgestattet werden, so dass ein höherer Federdruck auf die Unterseite des zu testenden elektronischen Bauteils ausgeübt wird. Die Kontaktplatte 15 dieser mit Federspangen 30 ausgestatteten Kontaktplatte weisen ebenfalls drei Abschnitte auf, nämlich einen Kontaktabschnitt 12, dessen Ende den Federkontakt 5 bildet, einen Federabschnitt 13 mit der Federspange 30 und eine Halteabschnitt 14, der das Kontaktelement 4 fixiert. Bei dem Zusammenbau der einzelnen Modulbausteine 8 mit den Eckstücken 18 zu einem Testsockel 3 können die drei Modulbausteine 81, 82 und 83 auch gemischt eingesetzt werden, je nach Anforderung an das Testverfahren. Die Kontaktelemente 4 in Form von Vierkantstiften 49 sind von Modulbaustein 8 zu Modulbaustein 8 versetzt angeordnet, um eine ausreichende Spannungsfestigkeit zwischen den Kontaktelementen zu gewährleisten. Entsprechend sind die Steckbuchsen 35 auf der Prüfplatte 47 zur Aufnahme des zusammengebauten Testsockels 3 entsprechend versetzt angeordnet.

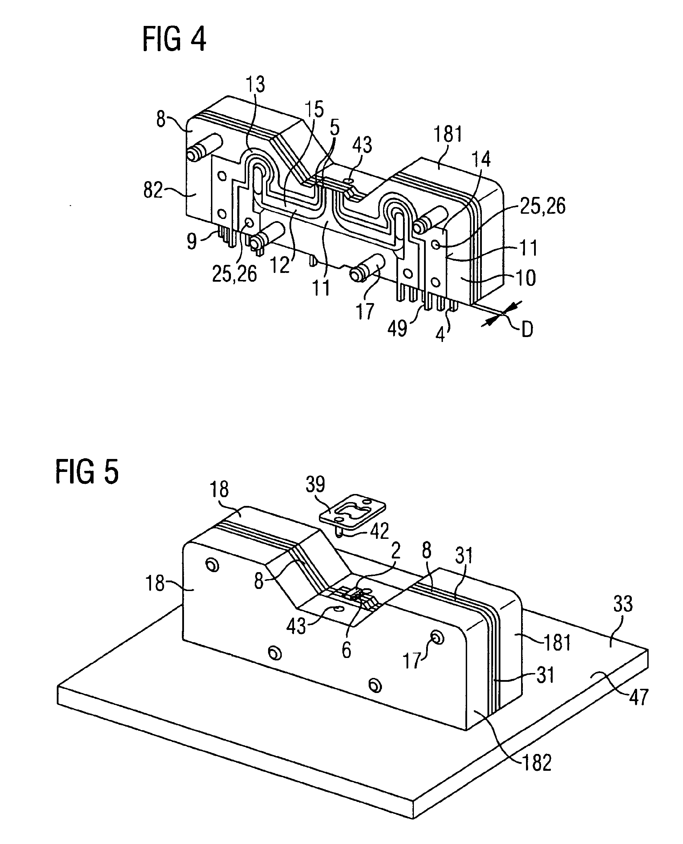

Figur 4 zeigt eine schematische perspektivische Ansicht eines teilweisen Zusammenbaus des Testsockels der Figur 3. Komponenten mit gleichen Funktionen wie in den vorhergehenden Figuren werden mit gleichen Bezugszeichen gekennzeichnet und nicht extra erörtert.

Für den in Figur 4 teilweise zusammengesetzten Testsockel wurden drei Modulbausteine 82, wie sie in Figur 2 gezeigt werden, zusammengesetzt. Der Unterschied zwischen den einzelnen Modulbausteinen besteht lediglich darin, dass die Vierkantstifte 49 von Modulbaustein 8 zu Modulbaustein 8 zur Erhöhung der Spannungsfestigkeit versetzt angeordnet sind. Die drei Modulbausteine 82 sind auf die Zentrierbolzen 17 des Endstückes 181 passgenau aufgesetzt und bilden paarweise angeordnete Federkontakte 5, die dem zu testenden Bauteil 2 in ihrer Anzahl und ihrer Schrittweite angepaßt sind.

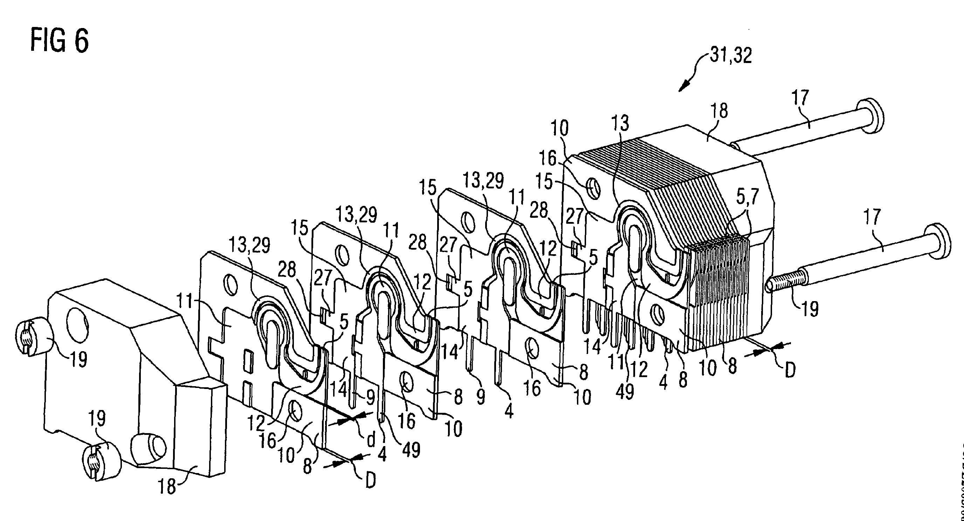

Figur 5 zeigt den vollständigen Zusammenbau des Testsockels 3 der Figur 3. Komponenten mit gleichen Funktionen wie in den vorhergehenden Figuren werden mit gleichen Bezugszeichen gekennzeichnet und nicht extra erörtert. Durch Einbringen oder Andrücken der Kontaktelemente 4, die in den Figuren 3, 4, 6 bis 14 gezeigt werden, in die Steckbuchsen der Prüfplatte 47 beziehungsweise durch Andrücken der Kontaktelemente auf Umverdrahtungsstrukturen der Prüfplatte 47 wird der Testsockel mit Leiterbahnen der Prüfplatte 47 verbunden und es können an die Prüfplatte 47 entsprechende Testgeräte angeschlossen werden.

Figur 6 zeigt eine schematische auseinandergezogene perspektivische Ansicht einer Testsockelhälfte 32 einer dritten Ausführungsform der Erfindung. Komponenten mit gleichen Funktionen wie in den vorhergehenden Figuren werden mit gleichen Bezugszeichen gekennzeichnet und nicht extra erörtert.

Diese Testsockelhälfte weist insgesamt zwanzig Modulbausteine 8 auf, die mit Hilfe der Zentrierbolzen 17 über Schraubverbindungen 19 gestapelt und zusammengehalten werden können. Die Kontaktplatte 15 ist im Bereich des Halteabschnitts 14 unterschiedlich zur Ausführungsform der Figur 3 gestaltet. Der Halteabschnitt 14 wird nämlich in dieser Ausführungsform nicht durch Passöffnungen im Halteabschnitt selbst in der strukturierten Aussparung 11 der isolierenden Trägerplatte 10 gehalten, sondern durch eine Arretierungsfahne 27 des Halteabschnitts 14, die in eine angepasste Aussparung 28 der Trägerplatte 10 eingreift. Die Trägerplatte 10 kann aus Polyimid, Polyethylen, Polypropylen, Polytetrafluorethylen und/oder einem Epoxidharz hergestellt sein, wobei zur Erhöhung ihrer Stabilität eine Verstärkung durch keramische oder durch Glasfasern vorgesehen werden kann.

Der Federabschnitt 13 der Kontaktplatte ist wiederum ein Spiralfederbogen, der über den starren Arm 44 mit dem Federkontakt 5 verbunden ist. Die Materialstärke D der Trägerplatte entspricht der Materialstärke der Modulbausteine 8 und liegt zwischen 0,3 und 1 mm. Im Bereich der strukturierten Aussparung 11 ist die Trägerplatte auf eine Materialstärke von bis zu 0,05 mm abgearbeitet worden, um die Kontaktplatte 15 in der Aussparung unterzubringen. Die minimale Materialstärke im Bereich der Aussparung von 0,05 ist derart gewählt, dass noch eine sichere Isolierung zu den benachbarten Kontaktplatten durch die Trägerplatte gewährleistet ist. Die in Figur 6 gezeigte Testsockelhälfte 32 mit einem Stapel 31 aus Modulbausteinen 8 kann auch als Testsockelviertel eingesetzt werden für Bauteile, die nicht nur an zwei Seitenkanten Außenkontakte aufweisen, sondern auf allen vier Kanten des elektronischen Bauteils Außenkontakte aufweisen.

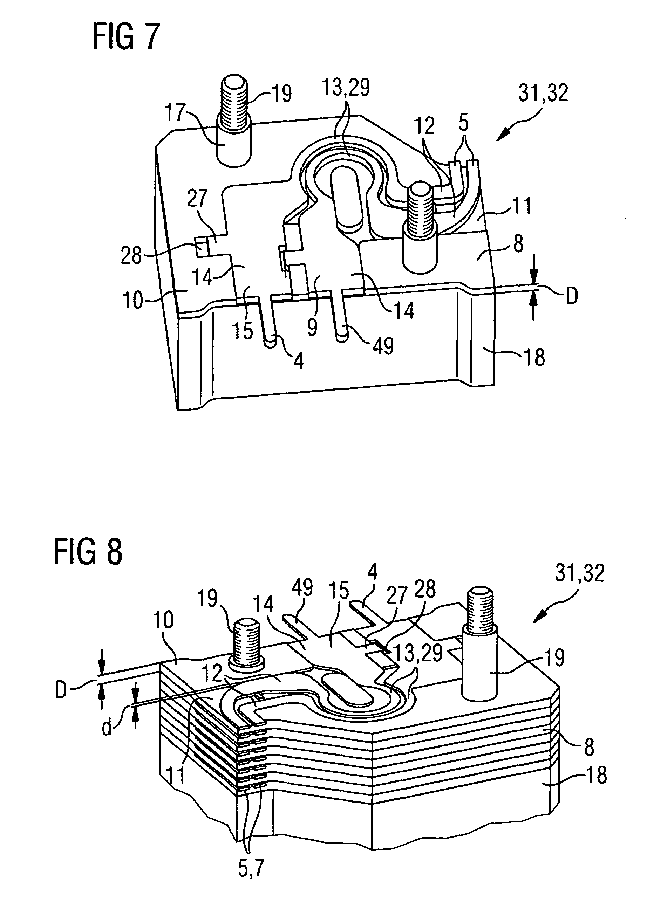

Figur 7 zeigt eine schematische perspektivische Ansicht einer Testsockelhälfte 32 mit Blick auf die Kontaktelemente 4 eines auf ein Eckstück 18 aufgelegten Modulbausteins 8. Komponenten mit gleichen Funktionen wie in den vorhergehenden Figuren werden mit gleichen Bezugszeichen gekennzeichnet und nicht extra erörtert.

Das Eckstück 18 weist zwei Zentrierbolzen 17 auf, auf die der Modulbaustein 8 passgenau gesteckt werden kann. Die aus dem Modulbaustein herausragenden Kontaktelemente 4 werden durch den Halteabschnitt 14 gehalten und vor einem Verschieben durch eine Arretierungsfahne 27, die passgenau in einer Aussparung 28 angeordnet ist, fixiert. Während der Halteabschnitt 14 somit lokal festgelegt ist, kann der Federabschnitt 13, der aus einem Spiralbogen besteht, aufgrund einer entsprechenden Spielpassung verformt werden. Durch diese Spielpassung des Federabschnitts ist es möglich, dass der nach außen herausragende Federkontakt 5, auf den der Außenkontakt des zu testenden elektronischen Bauteils mit integrierter Schaltung aufzulegen ist, federelastisch nachgibt. Die Restmaterialstärke d der isolierende Trägerplatte 10 des Modulbausteins 8 ist im Bereich der strukturierten Aussparungen 11 größer als 0,05 mm.

Figur 8 zeigt eine schematische perspektivische Ansicht eines Endstücks 18 einer Testsockelhälfte 32 mit Blick auf die Federkontakte von acht aufeinandergestapelten Modulbausteinen 8. Komponenten mit gleichen Funktionen wie in den vorhergehenden Figuren werden mit gleichen Bezugszeichen gekennzeichnet und nicht extra erörtert.

Die Figur 8 zeigt eine dichte Packung von Modulbausteinen und damit eine dichte Packung von Federkontakten 5, die um 0,2 bis 0,3 mm aus dem jeweiligen Modulbaustein herausragen. Dieser herausragende Abschnitt entspricht der Spielpassung, die der Kontaktabschnitt und der Federabschnitt der Kontaktplatte 15 in der Aussparung 11 der isolierenden Trägerplatte 10 aufweist. Der Halteabschnitt ist ähnlich geformt und fixiert durch eine Arretierungsfahne 27, wie in den Figuren 7 und 6. Mit Figur 8 wird die Flexibilität des erfindungsgemäßen Testsockels gezeigt und die Stapelfähigkeit der Modulbausteine 8 demonstriert. Die Federelemente können aus Federbronze wie Berilliumbronze hergestellt sein, die sich als zuverlässiger Werkstoff für dauerelastische Einsätze bewährt hat. Um eine Kontaktgabe der Federkontakte 5 zu sichern, ist die Oberfläche der Federkontakte in dem Kontaktbereich zu den Außenkontakten eines zu testenden Bauteiles mit einer Edelmetallbeschichtung versehen.

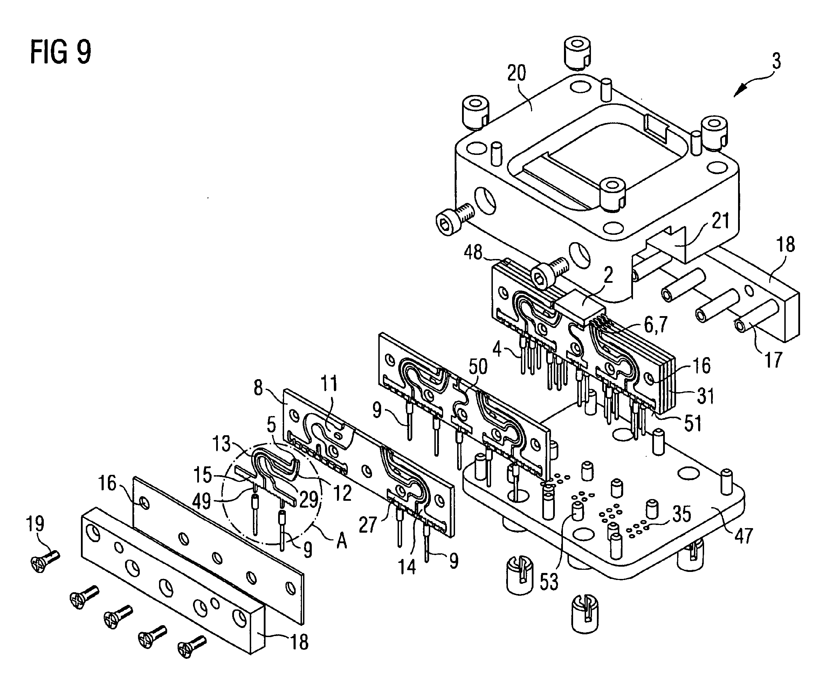

Figur 9 zeigt eine schematische perspektivische Ansicht einer Testvorrichtung einer vierten Ausführungsform der Erfindung mit einem Testsockel 3 für Funktions-Testserien von Bauteilen 2 integrierter Schaltungen. Komponenten mit gleichen Funktionen wie in den vorhergehenden Figuren werden mit gleichen Bezugszeichen gekennzeichnet und nicht extra erörtert.

Die vierte Ausführungsform der Erfindung unterscheidet sich von den ersten drei Ausführungsformen der Erfindung dadurch, dass die beiden Endstücke 18, die den Stapel 31 aus Modulbausteinen 8 zusammenhalten, im zusammengebauten Zustand in einen Gehäuserahmen 20 einsetzbar sind, der zur Aufnahme der Endstücke 18 mit den Modulbausteinen 8 eine Aussparung 21 in dem Gehäuserahmen 20 aufweist.

Ein weiterer Unterschied besteht in der äußeren Kontur der Modulbausteine 8. Während die Oberseite des Modulbaustapels in den ersten drei Ausführungsformen eine mittige Vertiefung aufweist, in der ein zu testendes Bauelement platziert werden kann, ist in dieser vierten Ausführungsform der Erfindung ein glatter oberer Rand vorgesehen, aus dem die Federkontakte 5 herausragen, so dass ein zu testendes elektronisches Bauteil 2 nicht in eine Mulde einzusetzen ist, sondern einfach flach auf den Testsockel aufgesetzt werden kann. Dies hat den Vorteil, dass eine schneller Wechsel beim automatischen Platzieren der zu testenden Bauteile bei Serienfunktionstest erfolgen kann und somit die Testkosten vermindert werden.

Ein weiterer Unterschied dieser vierten Ausführungsform der Erfindung gegenüber den vorhergehenden Ausführungsformen besteht darin, dass die Prüfplatte 47 beabstandet von der Unterseite 51 des Stapels 31 von Modulbausteinen angeordnet ist, wobei Abstandshalter 53 einen definierten Abstand sichern. Mit diesem Abstand zwischen der Unterseite des Testsockels und der Oberseite der Prüfplatte 47 wird gewährleistet, dass der Testsockel 3, der mit extremen Temperaturen bei Serientests in einer automatischen Testvorrichtung belastet wird, thermisch von der Prüfplatte entkoppelt ist. Die Vierkantstifte 49, wie sie in den vorhergehenden drei Ausführungsformen dargestellt werden, werden für die vierte Ausführungsform, die in Figur 9 gezeigt wird, durch Teststifte 9 verlängert, so dass sie einerseits den entstehenden Abstand durch die Abstandshalter 53 überbrücken können und andererseits in den Steckbuchsen 35 der Prüfplatte 47 eingeführt werden können.

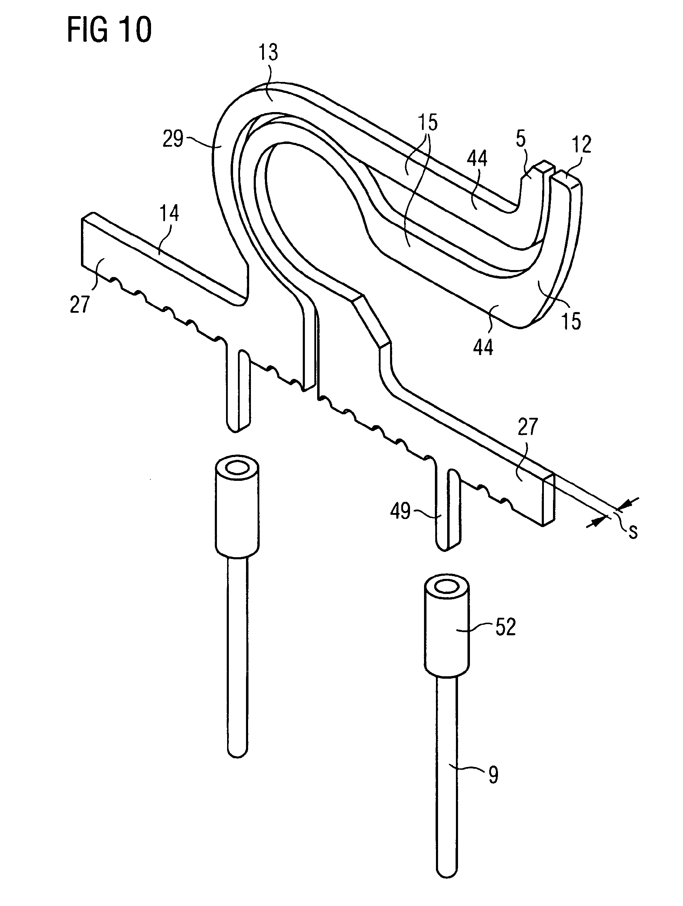

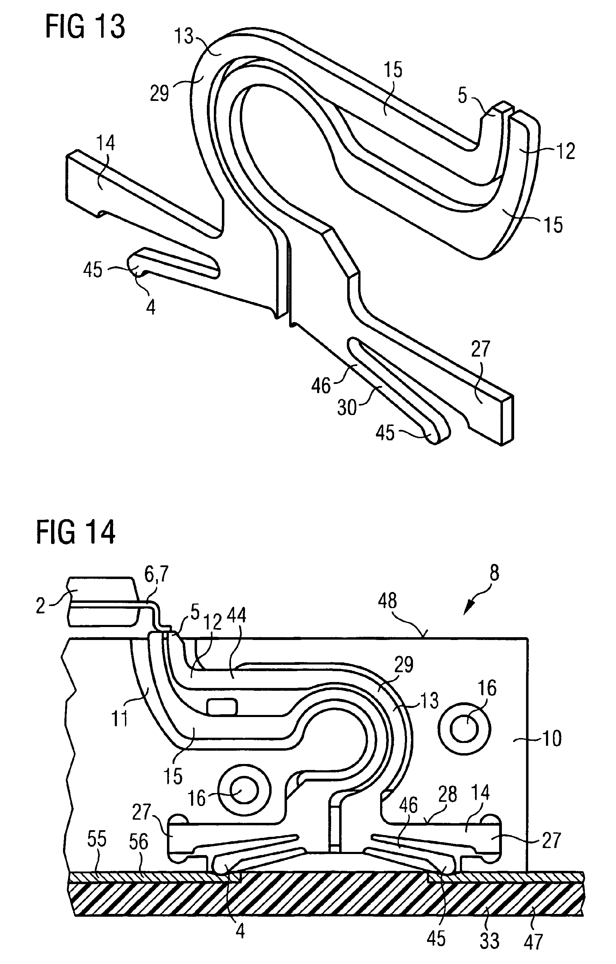

Weitere Details dieser vierten Ausführungsform der Erfindung werden mit den Figuren 10 bis 14 erläutert. Diese Figuren zeigen insbesondere Unterschiede in der Strukturierung und Gestaltung der Kontaktplatten 15 und der Kontaktelemente 4, die einmal in starrer Form als Stifte 9 ausgeführt sein können, wie es in den Figuren 9 bis 12 gezeigt ist, oder als Kontaktfeder 45, wie es in den Figuren 13 und 14 gezeigt wird.

Figur 10 zeigt eine schematische perspektivische Ansicht von zwei Kontaktplatten mit zwei Federkontakten 5 zum gemeinsamen Kontaktieren und Verbinden eines einzelnen Außenkontaktes eines Bauteils mit Teststiften 9 auf der Unterseite eines Testsockels. Komponenten mit gleichen Funktionen wie in den vorhergehenden Figuren werden mit gleichen Bezugszeichen gekennzeichnet und nicht extra erörtert.

Bei dieser vierten Ausführungsform der Erfindung sind zwei Kontaktplatten 15 derart benachbart angebracht, dass sie mit ihren Federkontakten 5 gleichzeitig einen Außenkontakt eines elektronischen Bauteils kontaktieren können. Der Spiralbogen 29 des Federabschnitts 13 wird im Halteabschnitt 14 von einer parallel zur Unterkante des Testsockels angeordneten Arretierungsfahne 27 gehalten. Der Federabschnitt 12, der in seiner Ausrichtung durch die Arretierungsfahne 27 gehalten wird, geht über in einen Kontaktabschnitt 12, der nach außen die Federkontakte 5 aufweist und innerhalb der Aussparung einer Isolierplatte Federarme 44 aufweist, die einen größeren Querschnitt besitzen als der Querschnitt der Spiralbogenteile des Federabschnitts. Die Arretierungsfahne 27 liefert in der angepassten nicht gezeigten Aussparung einer isolierenden Trägerplatte das Widerlager für den Federabschnitt und gleichzeitig hält sie den Halteabschnitt bereit, von dem aus Vierkantstifte 49 aus der Unterseite des Testsockels herausragen und einen viereckigen Querschnitt aufweisen. Zur Verlängerung dieser viereckigen Querschnitte wird auf den Vierkantstift 49 eine zylindrische Hülse 52 kraftschlüssig aufgepresst, so dass der Teststift 9 den starren Vierkantstift 49 der Arretierungsfahne 27 verlängert.

Jede Arretierungsfahne 27 kann in dieser Ausführungsform der Erfindung sieben Vierkantstifte 49 aufweisen, wobei in dieser Ausführungsform nach Figur 10 lediglich eine Position der möglichen sieben Positionen mit einem Vierkantstift 49 versehen ist. Und die anderen 6 Vierkantstifte wahlweise entfernt sind.

Figur 11 zeigt eine schematische Seitenansicht eines Teils eines Modulbausteins 8 mit Kontaktplatte 15, wie sie in Figur 10 gezeigt wird, mit Teststiften 9 zu einer Prüfplatte 47. Komponenten mit gleichen Funktionen wie in den vorhergehenden Figuren werden mit gleichen Bezugszeichen gekennzeichnet und nicht extra erörtert.

In diesem Ausführungsbeispiel sind wieder zwei Kontaktplatten für einen Außenkontakt 6 in einer Außenkontaktposition 7 vorgesehen. Der Außenkontakt 6 ist hier mit zwei Federkontakten 5 von zwei voneinander isolierten Kontaktplatten 15 versehen, so dass eine der Kontaktplatten ein Testsignal zur Verfügung stellt, während die andere Kontaktplatte überprüft, ob das Testsignal am Außenkontakt 6 ansteht. Von den vier Vierkantkontakten 49, die jeder Kontaktplatte dieses Ausführungsbeispiels zur Verfügung stehen, sind lediglich jeweils zwei durch Teststifte 9 verlängert, so dass sie die Testbuchsen 35 der Prüfplatte 47 in einem Abstand a von der Unterseite 51 des Testsockels 3 erreichen. Dieser Abstand a dient der thermischen Entkopplung von Prüfplatte und Unterkante Stecksockel. Die Unterseite des Testsockels 51 kann zusätzlich einen thermische Isolierschicht beispielsweise aus Styropor aufweisen. Umverdrahtungsleitungen 55 einer Umverdrahtungsstruktur können die Unterseite der Prüfplatte bilden, um Signale an die Teststifte 9 heranzuführen.

Figur 12 zeigt eine schematische Seitenansicht einer Kontaktplatte. Komponenten mit gleichen Funktionen wie in den vorhergehenden Figuren werden mit gleichen Bezugszeichen gekennzeichnet und nicht extra erörtert.

Die Kontaktplatte 15 hat als Federabschnitt 13 ein S-förmiges Federelement. Dieses S-förmige Federelement kann kompakter als eine Federstange dargestellt werden und wird von einer Arretierungsfahne 27 in Position in einer Aussparung einer isolierenden Trägerplatte gehalten. Die Kontaktelemente 4 sind in dieser Ausführungsform der Erfindung Vierkantstifte 49, die in eine zylindrische Hülse eines Teststiftes 9, der in Figur 10 gezeigt wird, eingeführt und damit verlängert werden kann. Derartige S-förmige Federelemente werden vorzugsweise zur Kontaktierung der Unterseite des zu testenden elektronischen Bauteils eingesetzt, um dadurch den Isolationswiderstand zwischen dem Bodenbereich eines elektronischen Bauteils und den unterschiedlichen Außenkontakten festzustellen. Dazu drückt das S-förmige Federelement mit seinem Federkontakt 5 gegen die Unterseite des zu testenden elektronischen Bauteils.

Figur 13 zeigt eine schematische perspektivische Ansicht von zwei Kontaktplatten 15 zum gemeinsamen Kontaktieren und Verbinden eines einzelnen Außenkontaktes eines Bauteils mit Kontaktfedern 45 auf der Unterseite eines Testsockels. Komponenten mit gleichen Funktionen wie in den vorhergehenden Figuren werden mit gleichen Bezugszeichen gekennzeichnet und nicht extra erörtert.

Die Kontaktfedern 45 ragen aus der Unterseite eines Testsockels heraus und sind in dieser Ausführungsform der Erfindung als Spreizfedern 46 ausgebildet, die sich von einer Arretierungsfahne 27 des Halteabschnitts 14 der Kontaktplatte 15 erstrecken. Diese Kontaktfedern 45 können unmittelbar auf eine Metallstruktur einer Prüfplatte 47 zur Kontaktierung einer Umverdrahtungsstruktur 56 gepresst werden.

Figur 14 zeigt eine schematische Seitenansicht eines Teils eines Modulbausteins 8 mit Kontaktplatten 15, wie sie in Figur 13 gezeigt werden, mit Kontaktfedern 45 zu einer Prüfplatte 47. Komponenten mit gleichen Funktionen wie in den vorhergehenden Figuren werden mit gleichen Bezugszeichen gekennzeichnet und nicht extra erörtert.

In diesem Ausführungsbeispiel sind wieder zwei Kontaktplatten für einen Außenkontakt 6 in einer Außenkontaktposition 7 eines zu testenden Bauteils 2 vorgesehen. Der Außenkontakt 6 ist hier mit zwei Federkontakten 5 von zwei voneinander isolierten Kontaktplatten 15 in Kontakt, so dass eine der Kontaktplatten ein Testsignal zur Verfügung stellt, während die andere Kontaktplatte überprüft, ob das Testsignal am Außenkontakt 6 ansteht. Anstelle der in Figur 11 gezeigten Vierkantkontakte weist jede der Kontaktplatten 15 eine Kontaktfeder 45 auf, die unmittelbar auf eine Umverdrahtungsleitung einer Prüfplatte 47 gepresst wird, so dass sich die Signalwege verkürzen.

## Patentansprüche

1. Testvorrichtung für Bauteile (2) integrierter Schaltungen mit einem Testsockel (3), aus dem Kontaktelemente (4) auf einer Unterseite des Testsockels herausragen und mit Federkontakten (5), die aus einer der Unterseite des Testsockels gegenüberliegenden Oberseite des Testsockels herausragen und mit den Außenkontakten (6) eines zu testenden integrierten Schaltungstyps elektrisch kontaktierbar sind, wobei für jede Außenkontaktposition (7) des Schaltungstyps ein Modulbaustein (8) mit mindestens einer elektrisch leitenden Kontaktplatte (15) und mit einer isolierenden Trägerplatte (10) vorgesehen ist, wobei die Kontaktplatte (15) in einer strukturierten Aussparung (11) der Trägerplatte (10) angeordnet ist und wobei die Kontaktplatte mindestens einen Kontaktabschnitt (12), einen Federabschnitt (13) und einen Halteabschnitt (14) mit mindestens einem der aus der Unterseite des Testsockels (3) herausragenden Kontaktelemente (4) hält und wobei alle Modulbausteine (8) für den vorgegebenen integrierten Schaltungstyp zu dem Testsockel (3) aus mindestens einem Stapel von Modulbausteinen (8) zusammengebaut sind, **gekennzeichnet dadurch, dass** jeder Modulbaustein (8) mindestens zwei Passöffnungen (16) aufweist, durch die Zentrierbolzen (17) führen, die zwei Endstücke (18) miteinander verbinden, wobei die Endstücke (18) und die Zentrierbolzen (17) die Modulbausteine (8) passgenau gestapelt zu einem Testsockel (3) zusammenhalten.

2. Testvorrichtung nach Anspruch 1,
**dadurch gekennzeichnet, dass**
der Modulbaustein (8) für jeden Außenkontakt (6) zwei voneinander isoliert in zwei Aussparungen (11) angeord-nete Kontaktplatten (15) mit jeweils zwei Federkontakten (5) aufweist, die beim Testen mit einem einzelnen Außenkontakt (6) verbunden sind.

3. Testvorrichtung nach Anspruch 1 oder Anspruch 2,
**dadurch gekennzeichnet, dass**
die mindestens eine Kontaktplatte (15) in dem Federabschnitt (13) der Kontaktplatte (15) einen Spiralfederbogen (29) aufweist.

4. Testvorrichtung nach Anspruch 1 oder Anspruch 2,
**dadurch gekennzeichnet, dass**
die mindestens eine Kontaktplatte (15) in dem Federabschnitt (13) der Kontaktplatte (15) eine Federspange (30) aufweist.

5. Testvorrichtung nach Anspruch 1 oder Anspruch 2,
**dadurch gekennzeichnet, dass**
die mindestens eine Kontaktplatte (15) in dem Federabschnitt (13) der Kontaktplatte (15) ein S-förmiges Federelement aufweist.

6. Testvorrichtung nach einem der vorhergehenden Ansprüche,
**dadurch gekennzeichnet, dass**
das aus der Unterseite herausragende Kontaktelement (4) mindestens einen starren Teststift (9) aufweist.

7. Testvorrichtung nach einem der Ansprüche 1 bis 5,
**dadurch gekennzeichnet, dass**
das aus der Unterseite herausragende Kontaktelement (4) mindestens eine Kontaktfeder (45) aufweist.

8. Testvorrichtung nach Anspruch 7,
**dadurch gekennzeichnet, dass**
die Kontaktfeder (45) auf der Unterseite des Testsockels (3) als Spreizfeder (46) ausgebildet ist und federelastisch von dem Halteabschnitt (14) der Kontaktplatte (15) weggespreizt ist.

9. Testvorrichtung nach Anspruch 1 oder Anspruch 2,
**dadurch gekennzeichnet, dass**
der Halteabschnitt (14) mehrere starre Kontaktelemente aufweist, die als Vierkantstifte (49) aus der Unterseite des Testsockels (3) herausragen und bis auf einen, der mit einem zylindrischen Teststift (9) kraftschlüssig verbunden und verlängert ist, gekürzt sein können.

10. Testvorrichtung nach einem der vorhergehenden Ansprüche,
**dadurch gekennzeichnet, dass**
die Kontaktelemente (4) der einzelnen Modulbausteine (8) auf der Unterseite des Testsockels (3) versetzt zueinander angeordnet sind.

11. Testvorrichtung nach einem der vorhergehenden Ansprüche,
**dadurch gekennzeichnet, dass**
die Kontaktelemente (4) mit einer Umverdrahtungsstruktur auf einer Prüfplatte (47) über Kontaktfedern (45) elektrisch verbunden sind.

12. Testvorrichtung nach einem der vorhergehenden Ansprüche,
**dadurch gekennzeichnet, dass**
die Kontaktelemente (4) über zylindrische Teststifte mit einer Umverdrahtungsstruktur auf einer Prüfplatte (47) über Steckbuchsen (35)verbunden sind.

13. Testvorrichtung nach einem der vorhergehenden Ansprüche,
**dadurch gekennzeichnet, dass**
jeder Modulbaustein (8) eine Materialstärke (D) zwischen 0,3 mm und 1 mm aufweist.

14. Testvorrichtung nach einem der vorhergehenden Ansprüche,
**dadurch gekennzeichnet, dass**
jede Trägerplatte (10) eine Gesamtmaterialstärke (D) zwischen 0,3 mm und 1 mm und eine minimale Materialstärke (d) im Bereich der Aussparungen (11) für die mindestens eine Kontaktplatte (15) von größer gleich 0,05 mm aufweist.

15. Testvorrichtung nach einem der vorhergehenden Ansprüche,
**dadurch gekennzeichnet, dass**
die Kontaktplatte (15) eine Materialstärke (s) von 0,050 bis 0,750 mm aufweist.

16. Testvorrichtung nach einem der vorhergehenden Ansprüche,
**dadurch gekennzeichnet, dass**
die mindestens eine Kontaktplatte (15) in dem Halteabschnitt (14) eine Passöffnung (25) aufweist, in die ein angepasster Vorsprung (26) der Trägerplatte (10) eingreift.

17. Testvorrichtung nach einem der vorhergehenden Ansprüche,
**dadurch gekennzeichnet, dass**
die mindestens eine Kontaktplatte (15) in dem Halteabschnitt (14) eine Arretierfahne (27) aufweist, die in eine angepasste Aussparung (28) der Trägerplatte (10) eingreift.

18. Testvorrichtung nach einem nach einem der vorhergehenden Ansprüche,
**dadurch gekennzeichnet, dass**
die mindestens eine Kontaktplatte (15) in dem Kontaktabschnitt (12) der Kontaktplatte (15) eine Spielpassung gegenüber der strukturierten Aussparung (11) der Trägerplatte (10) von 0,2 bis 0,3 mm aufweist, um eine entsprechende Kontaktfederauslenkung des Kontaktabschnitts (12) zuzulassen.

19. Testvorrichtung nach einem der vorhergehenden Ansprüche,
**dadurch gekennzeichnet, dass**
Zentrierbolzen (17) mit einem der Endstücke (18) verbunden sind und das zweite der Endstücke (18) über Schraubverbindungen (19) halten.

20. Testvorrichtung nach Anspruch 19,
**dadurch gekennzeichnet, dass**
die Endstücke (18) für einzelne Vortests des Testsockels einen Rahmen (22) tragen, der seinerseits eine Schwenkvorrichtung (23) aufweist, die auf ein zu testendes Bauteil (2) mit integrierter Schaltung unter Federkontaktgabe zwischen den Außenkontakten (6) des zu testenden Bauteils (2) und den Federkontakten (5) auf der Oberseite (48) des Testsockels (3) schwenkbar ist.

21. Testvorrichtung nach Anspruch 20,
**dadurch gekennzeichnet, dass**
der Rahmen (22) für Vortests eine der Schwenkvorrichtung (23) gegenüberliegende Schnappvorrichtung (24) aufweist, mit der die Schwenkvorrichtung (23) zur Fixierung des zu testenden Bauteils (2) bei Vortests in Eingriff bringbar ist.

22. Testvorrichtung nach Anspruch 21,
**dadurch gekennzeichnet, dass**
die Schnappvorrichtung für Vortests eine U-förmige Klinke (36) aufweist, mit der ein stabförmiges Bedienelement (37) der Schwenkvorrichtung (23) in einer Verriegelungsposition der Testvorrichtung (1) in Eingriff steht.

23. Testvorrichtung nach einem der Ansprüche 20 bis 22,
**dadurch gekennzeichnet, dass**
die Schwenkvorrichtung (23) für Vortests einen Einsatz (38) aufweist, welcher der Kontur des zu testenden Bauteils (2) angepaßt ist und in der Verriegelungsposition der Testvorrichtung (1) das Bauteil (2) mit seinen Außenkontakten (6) auf die Kontaktplatte () des Testsockels (3) presst.

24. Testvorrichtung nach einem der vorhergehenden Ansprüche,
**dadurch gekennzeichnet, dass**
die Testvorrichtung (1) vier Endstücke (18) und zwei Stapel (31) aus Modulbausteinen (8) aufweist, wobei jeder Stapel (31) aus Modulbausteinen (8) eine Testsockelhälfte (32) bildet, wobei die beiden Testsockelhälften (32) einander gegenüberliegend angeordnet sind und auf einer Grundplatte (33) in Position von jeweils einer durch jedes Endstück (18) geführten Passschraube (34) gehalten sind.

25. Testvorrichtung nach einem der vorhergehenden Ansprüche,
**dadurch gekennzeichnet, dass**
die Testvorrichtung (1) eine Prüfplatte (47) mit Steckbuchsen (35) zur Aufnahme der Teststifte (4) der einzelnen Modulbausteine (8) aufweist.

26. Testvorrichtung nach einem der vorhergehenden Ansprüche,
**dadurch gekennzeichnet, dass**
das Material der Trägerplatte (10) Polyimid, Polyethylen, Polypropylen oder ein Epoxidharz aufweist.

27. Testvorrichtung nach einem der vorhergehenden Ansprüche,
**dadurch gekennzeichnet, dass**
die Kontaktplatte (15) eine Federbronze aufweist und im Kontaktabschnitt (12) eine Beschichtung aus einem Edelmetall, vorzugsweise einer Kontaktgoldlegierung aufweist.

28. Testvorrichtung nach einem der vorhergehenden Ansprüche,
**dadurch gekennzeichnet, dass**
die Endstücke (18), die Zentrierbolzen (17) und/oder Passschrauben (34) einen Chrom-Nickel-Stahl aufweisen.

## Claims

1. Test device for components (2) of integrated circuits having a test receptacle (3), from which contact elements (4) project on an underside of the test receptacle, and having spring contacts (5), which project from a top side of the test receptacle opposite to the underside of the test receptacle and are electrically contactable to the external contacts (6) of an integrated circuit type to be tested, a module component (8) having at least one electrically conductive contact plate (15) and having an insulating carrier plate (10) being provided for each external contact position (7) of the circuit type, the contact plate (15) being arranged in a patterned cutout (11) of the carrier plate (10), and the contact plate holding at least one contact section (12), a spring section (13) and a holding section (14) with at least one of the contact elements (4) projecting from the underside of the test receptacle (3), and all the module components (8) for the predetermined integrated circuit type being assembled to form the test receptacle (3) comprising at least one stack of module components (8),
**characterized in that**
each module component (8) comprises at least two fitting openings (16) through which lead centring bolts (17) that connect two end pieces (18) to one another, the end pieces (18) and the centring bolts (17) holding the module components (8) together with an accurate fit in stacked fashion to form a test receptacle (3).

2. Test device according to Claim 1,
**characterized in that**
the module component (8) has, for each external contact (6), two contact plates (15) - arranged in a manner insulated from one another in two cutouts (11) - with in each case two spring contacts (5), which are connected to an individual external contact (6) during testing.

3. Test device according to Claim 1 or Claim 2,
**characterized in that**
the at least one contact plate (15) has a spiral spring arc (29) in the spring section (13) of the contact plate (15).

4. Test device according to Claim 1 or Claim 2,
**characterized in that**
the at least one contact plate (15) has a spring clasp (30) in the spring section (13) of the contact plate (15).

5. Test device according to Claim 1 or Claim 2,
**characterized in that**
the at least one contact plate (15) has an S-shaped spring element in the spring section (13) of the contact plate (15).

6. Test device according to one of the preceding claims,
**characterized in that**
the contact element (4) projecting from the underside has at least one rigid test pin (9).

7. Test device according to one of Claims 1 to 5,
**characterized in that**
the contact element (4) projecting from the underside has at least one contact spring (45).

8. Test device according to Claim 7,
**characterized in that**
the contact spring (45) is formed on the underside of the test receptacle (3) as a spreading spring (46) and is spread away spring-elastically from the holding section (14) of the contact plate (15).

9. Test device according to Claim 1 or Claim 2,
**characterized in that**
the holding section (14) has a plurality of rigid contact elements that project as square pins (49) from the underside of the test receptacle (3) and may be shortened apart from one that is lengthened and connected to a cylindrical test pin (9) in a friction-locking manner.

10. Test device according to one of the preceding claims,
**characterized in that**
the contact elements (4) of the individual module components (8) are arranged offset with respect to one another on the underside of the test receptacle (3).

11. Test device according to one of the preceding claims,
**characterized in that**
the contact elements (4) are electrically connected to a rewiring structure on a test board (47) via contact springs (45).

12. Test device according to one of the preceding claims,
**characterized in that**
the contact elements (4) are connected via cylindrical test pins to a rewiring structure on a test board (47) via plug sockets (35).

13. Test device according to one of the preceding claims,
**characterized in that**
each module component (8) has a material thickness (D) of between 0.3 mm and 1 mm.

14. Test device according to one of the preceding claims,
**characterized in that**
each carrier plate (10) has an overall material thickness (D) of between 0.3 mm and 1 mm and a minimum material thickness (d) in the region of the cutouts (11) for the at least one contact plate (15) of greater than or equal to 0.05 mm.

15. Test device according to one of the preceding claims,
**characterized in that**
the contact plate (15) has a material thickness (s) of 0.050 to 0.750 mm.

16. Test device according to one of the preceding claims,
**characterized in that**
the at least one contact plate (15) has, in the holding section (14), a fitting opening (25) into which an adapted projection (26) of the carrier plate (10) engages.

17. Test device according to one of the preceding claims,
**characterized in that**
the at least one contact plate (15) has, in the holding section (14), an arresting lug (27) which engages into an adapted cutout (28) of the carrier plate (10).

18. Test device according to one of the preceding claims,
**characterized in that**
the at least one contact plate (15) has, in the contact section (12) of the contact plate (15), a clearance fit with respect to the patterned cutout (11) of the carrier plate (10) of 0.2 to 0.3 mm in order to permit a corresponding contact spring deflection of the contact section (12).

19. Test device according to one of the preceding claims,
**characterized in that**
centring bolts (17) are connected to one of the end pieces (18) and hold the second of the end pieces (18) by means of screw connections (19).

20. Test device according to Claim 19,
**characterized in that**
the end pieces (18), for individual preliminary tests of the test receptacle, carry a frame (22) which, for its part, has a pivoting device (23), which can be pivoted onto a component (2) to be tested with an integrated circuit with spring contact-making between the external contacts (6) of the component (2) to be tested and the spring contacts (5) on the top side (48) of the test receptacle (3).

21. Test device according to Claim 20,
**characterized in that**
the frame (22), for preliminary tests, has a snap-action device (24) opposite the pivoting device (23), with which the pivoting device (23) can be brought into engagement for the purpose of fixing the component (2) to be tested during preliminary tests.

22. Test device according to Claim 21,
**characterized in that**
the snap-action device, for preliminary tests, has a U-shaped pawl (36), with which a bar-type operating element (37) of the pivoting device (23) is in engagement in a locking position of the test device (1).

23. Test device according to one of Claims 20 to 22,
**characterized in that**
the pivoting device (23), for preliminary tests, has an insert (38) that is adapted to the contour of the component (2) to be tested and, in the locking position of the test device (1), presses the component (2) with its external contacts (6) onto the contact plate (15) of the test receptacle (3).

24. Test device according to one of the preceding claims,
**characterized in that**
the test device (1) has four end pieces (18) and two stacks (31) comprising module components (8), each stack (31) comprising module components (8) forming a test receptacle half (32), the two test receptacle halves (32) being arranged opposite one another and being held in position on a baseplate (33) by a respective fitting screw (34) led through each end piece (18).

25. Test device according to one of the preceding claims,
**characterized in that**
the test device (1) has a test board (47) with plug sockets (35) for receiving the test pins (4) of the individual module components (8).

26. Test device according to one of the preceding claims,
**characterized in that**
the material of the carrier plate (10) has polyimide, polyethylene, polypropylene or an epoxy resin.

27. Test device according to one of the preceding claims,
**characterized in that**
the contact plate (15) has a spring bronze and, in the contact section (12) has a coating made of a noble metal, preferably a contact gold alloy.

28. Test device according to one of the preceding claims,
**characterized in that**
the end pieces (18), the centring bolts (17) and/or fitting screws (34) have a chromium-nickel steel.

## Revendications

1. Dispositif d'essai pour composants (2) de circuits intégrés comprenant une embase d'essai (3), de laquelle sortent des éléments de contact (4) d'un côté inférieur de l'embase d'essai et comprenant des contacts à ressort (5) qui sortent d'un côté supérieur de l'embase d'essai opposé au côté inférieur de l'embase d'essai, et avec lesquels des contacts extérieurs (6) d'un type de circuit intégré à tester peuvent être mis en contact électrique, un composant modulaire (8) étant pourvu, pour chaque position de contact extérieur (7) du type de circuit, d'au moins une plaquette de contact électriquement conductrice (15) et d'une plaquette de support isolante (10), la plaquette de contact (15) étant disposée dans un évidement structuré (11) de la plaquette de support (10) et la plaquette de contact retenant au moins une portion de contact (12), une portion à ressort (13) et une portion de retenue (14) avec au moins l'un des éléments de contact (4) sortant du côté inférieur de l'embase d'essai (3), et tous les composants modulaires (8) pour le type de circuit intégré prédéfini étant assemblés pour former l'embase d'essai (3) à partir d'au moins un empilement de composants modulaires (8), **caractérisé en ce que** chaque composant modulaire (8) présente au moins deux ouvertures de passage (16) à travers lesquelles passent des goujons de centrage (17) qui relient entre elles deux pièces d'extrémité (18), les pièces d'extrémité (18) et les goujons de centrage (17) retenant ensemble les composants modulaires (8) de manière ajustée en pile pour former une embase d'essai (3).

2. Dispositif d'essai selon la revendication 1, **caractérisé en ce que** le composant modulaire (8) pour chaque contact extérieur (6) présente deux plaquettes de contact (15) isolées l'une de l'autre et disposées dans deux évidements (11), avec à chaque fois deux contacts à ressort (5), qui sont connectés lors de l'essai à un contact extérieur individuel (6).

3. Dispositif d'essai selon la revendication 1 ou 2, **caractérisé en ce que** l'au moins une plaquette de contact (15) présente dans la portion à ressort (13) de la plaquette de contact (15) un arc à ressort spiral (29).

4. Dispositif d'essai selon la revendication 1 ou 2, **caractérisé en ce que** l'au moins une plaquette de contact (15) présente dans la portion à ressort (13) de la plaquette de contact (15) une pince à ressort (30).

5. Dispositif d'essai selon la revendication 1 ou 2, **caractérisé en ce que** l'au moins une plaquette de contact (15) présente dans la portion à ressort (13) de la plaquette de contact (15) un élément à ressort en forme de S.

6. Dispositif d'essai selon l'une quelconque des revendications précédentes, **caractérisé en ce que** l'élément de contact (4) sortant du côté inférieur présente au moins une goupille d'essai rigide (9).

7. Dispositif d'essai selon l'une quelconque des revendications 1 à 5, **caractérisé en ce que** l'élément de contact (4) sortant du côté inférieur présente au moins un ressort de contact (45).

8. Dispositif d'essai selon la revendication 7, **caractérisé en ce que** le ressort de contact (45) est réalisé du côté inférieur de l'embase d'essai (3) sous forme de ressort à écartement (46) et est écarté élastiquement de la portion de retenue (14) de la plaquette de contact (15).

9. Dispositif d'essai selon la revendication 1 ou 2, **caractérisé en ce que** la portion de retenue (14) présente plusieurs éléments de contact rigides, qui sortent sous forme de goupilles carrées (49) du côté inférieur de l'embase d'essai (3) et qui, à l'exception d'un qui est connecté par engagement par force à une goupille d'essai cylindrique (9) et qui est prolongé, peuvent être raccourcis.

10. Dispositif d'essai selon l'une quelconque des revendications précédentes, **caractérisé en ce que** les éléments de contact (4) des composants modulaires individuels (8) sont disposés de manière décalée les uns par rapport aux autres du côté inférieur de l'embase d'essai (3).

11. Dispositif d'essai selon l'une quelconque des revendications précédentes, **caractérisé en ce que** les éléments de contact (4) sont connectés électriquement à une structure de modification de câblage sur une plaquette d'essai (47) par le biais de ressorts de contact (45).

12. Dispositif d'essai selon l'une quelconque des revendications précédentes, **caractérisé en ce que** les éléments de contact (4) sont connectés par le biais de goupilles d'essai cylindriques à une structure de modification de câblage sur une plaquette d'essai (47) par le biais de douilles (35).

13. Dispositif d'essai selon l'une quelconque des revendications précédentes, **caractérisé en ce que** chaque composant modulaire (8) présente une épaisseur de matériau (D) comprise entre 0,3 mm et 1 mm.

14. Dispositif d'essai selon l'une quelconque des revendications précédentes, **caractérisé en ce que** chaque plaquette de support (10) présente une épaisseur de matériau totale (D) comprise entre 0,3 mm et 1 mm et une épaisseur de matériau minimale (d) dans la région des évidements (11) pour l'au moins une plaquette de contact (15), supérieure ou égale à 0,05 mm.

15. Dispositif d'essai selon l'une quelconque des revendications précédentes, **caractérisé en ce que** la plaquette de contact (15) présente une épaisseur de matériau (s) comprise entre 0,050 et 0,750 mm.

16. Dispositif d'essai selon l'une quelconque des revendications précédentes, **caractérisé en ce que** l'au moins une plaquette de contact (15) présente dans la portion de retenue (14) une ouverture de passage (25) dans laquelle vient en prise une saillie adaptée (26) de la plaquette de support (10).

17. Dispositif d'essai selon l'une quelconque des revendications précédentes, **caractérisé en ce que** l'au moins une plaquette de contact (15) présente dans la portion de retenue (14) un drapeau de contact (27) qui vient en prise dans un évidement adapté (28) de la plaquette de support (10).

18. Dispositif d'essai selon l'une quelconque des revendications précédentes, **caractérisé en ce que** l'au moins une plaquette de contact (15) présente, dans la portion de contact (12) de la plaquette de contact (15), une adaptation du jeu par rapport à l'évidement structuré (11) de la plaquette de support (10) de 0,2 à 0,3 mm, afin de permettre une déviation correspondante du ressort de contact de la portion de contact (12).

19. Dispositif d'essai selon l'une quelconque des revendications précédentes, **caractérisé en ce que** des goujons de centrage (17) sont connectés à l'une des pièces d'extrémité (18) et retiennent la deuxième des pièces d'extrémité (18) par le biais de connexions vissées (19).

20. Dispositif d'essai selon la revendication 19, **caractérisé en ce que** les pièces d'extrémité (18) pour des essais préalables individuels de l'embase d'essai (3) portent un cadre (22) qui présente pour sa part un dispositif de pivotement (23) qui peut pivoter sur un composant à tester (2) avec un circuit intégré avec établissement d'un contact élastique entre les contacts extérieurs (6) du composant à tester (2) et les contacts à ressort (5) du côté supérieur (48) de l'embase d'essai (3).

21. Dispositif d'essai selon la revendication 20, **caractérisé en ce que** le cadre (22) pour les essais préalables présente un dispositif d'encliquetage (24) opposé au dispositif de pivotement (23), avec lequel le dispositif de pivotement (23) peut être amené en prise pour la fixation du composant à tester (2) au cours des essais préalables.

22. Dispositif d'essai selon la revendication 21, **caractérisé en ce que** le dispositif d'encliquetage pour essais préalables présente un cliquet en forme de U (36) avec lequel un élément d'actionnement en forme de barre (37) du dispositif de pivotement (23) est en prise dans une position de verrouillage du dispositif d'essai (1).

23. Dispositif d'essai selon l'une quelconque des revendications 20 à 22, **caractérisé en ce que** le dispositif de pivotement (23) pour essais préalables présente un insert (38) qui est adapté au contour du composant (2) à tester et qui, dans la position de verrouillage du dispositif d'essai (1), presse le composant (2) avec ses contacts extérieurs (6) sur la plaquette de contact (15) de l'embase d'essai (3).

24. Dispositif d'essai selon l'une quelconque des revendications précédentes, **caractérisé en ce que** le dispositif d'essai (1) présente quatre pièces d'extrémité (18) et deux empilements (31) de composants modulaires (8), chaque empilement (31) constitué de composants modulaires (8) formant une moitié d'embase d'essai (32), les deux moitiés d'embase d'essai (32) étant disposées en regard l'une de l'autre et étant maintenues en position sur une plaquette de base (33) par une vis de passage (34) guidée à travers chaque pièce d'extrémité (18).

25. Dispositif d'essai selon l'une quelconque des revendications précédentes, **caractérisé en ce que** le dispositif d'essai (1) présente une plaquette d'essai (47) avec des douilles (35) pour recevoir les goupilles d'essai (4) des composants modulaires individuels (8).

26. Dispositif d'essai selon l'une quelconque des revendications précédentes, **caractérisé en ce que** le matériau de la plaquette de support (10) présente du polyimide, du polyéthylène, du polypropylène ou une résine époxy.

27. Dispositif d'essai selon l'une quelconque des revendications précédentes, **caractérisé en ce que** la plaquette de contact (15) présente un bronze à ressort et, dans la portion de contact (12), un revêtement en métal noble, de préférence en un alliage d'or de contact.

28. Dispositif d'essai selon l'une quelconque des revendications précédentes, **caractérisé en ce que** les pièces d'extrémité (18), les goujons de centrage (17) et/ou les vis de passage (34) présentent un acier au chrome-nickel.
